# EUROPEAN PATENT SPECIFICATION

(11) **EP 1 817 976 B1**
(45) Date of publication and mention of the grant of the patent: **30.12.2009**
(21) Application number: 06002827.1
(22) Date of filing: 13.02.2006
(51) Int. Cl.: A45D 44/02, G06F 19/00, G06F 17/50

(54) **Methods for simulating custom hair color results and thereby selecting and formulating custom hair coloring compositions**
Verfahren zur Simulation individueller Haarfärbeergebnisse und anschließender Auswahl und Formulierung zugehöriger Haarfarbenzusammensetzungen
Procédés de simulation des résultats de colorations personnalisées des cheveux, et sélection et formulation de compositions personnalisées de colorations des cheveux

(43) Date of publication of application: 15.08.2007
(73) Proprietor: The Procter and Gamble Company, Cincinnati, Ohio 45202 (US)
(72) Inventor: Glattfelder, Martina, 68542 Heddesheim (DE); Schmenger, Jürgen, 64331 Weiterstadt (DE); Stähle, Tobias, 64319 Pfungstadt (DE)
(74) Representative: Hirsch, Uwe Thomas M.H.

(56) References cited:
- EP-A- 0 443 741
- EP-A- 1 138 374
- EP-A- 1 147 722
- EP-A- 1 374 720
- EP-A- 1 374 721
- EP-A- 1 380 820
- WO-A-01/91602
- WO-A-2005/089589
- JP-A- 2004 028 800
- JP-A- 2004 061 439
- US-A1- 2002 010 556

## Description

### FIELD OF THE INVENTION

The present invention relates to methods for simulating custom hair color results, methods for selecting a desired resulting custom hair color from among possible custom hair color results, and methods for formulating custom hair coloring compositions which impart to hair such custom hair color results. The present invention also relates to means for carrying out such methods, including related systems and hair coloring products.

The publication WO 2005/089589 A discloses a system for simulating a resulting custom hair color imparted to hair by a custom hair coloring composition formulated from a mixture of two different hair color preparations with a computer system for generating a visual image representative of a likely resulting custom hair color.

The EP 1 374 720 A discloses a method for selecting a desired resulting custom hair color imparted to hair by a hair dye product. There is a displaying for visual comparison of visual images representative of likely resulting hair colors.

The EP 0 443 741 A discloses an apparatus and a method to formulate a custom mixed cosmetic product in response to specific input criteria.

### BACKGROUND OF THE INVENTION

The alteration of the color of human hair by the application of hair dyes is well known. Generally, one who desires to alter the color of his or her hair has two options. He or she may choose to purchase a retail hair coloring kit for coloring his or her hair at home. Such retail hair coloring kits are available in an assortment of brands and shades, and, typically, provide suitable hair coloring or bleaching performance at a reasonable price and in a reasonable amount of time. Some consumers, however, prefer to alter the color of their hair with a hair coloring product which is not "off the shelf" and, which, instead, is more customized for their individual needs. Thus, alternatively, one may choose to go to a professional colorist at a hair salon for a professional hair coloring treatment. While invariably more expensive and often more time-consuming than altering hair color by using a retail hair coloring kit, a professional colorist can provide individualized advice to a client and can create a more customized or personalized hair coloring composition for imparting a custom hair color to a client's hair.

Most professional colorists have available for their use on a client's hair a myriad of different professional hair coloring products, including a variety of brands or product line-ups. Within individual brands or product line-ups, often numerous color shades exist. This variety allows the professional colorist, while utilizing his or her professional expertise and artistic creativity, to select one color shade, or to mix several different color shades together, to provide a customized hair coloring composition for a particular client. Such variety, though, can create complexity, which increases the potential for making an error in formulating such a custom hair color composition. In turn, any such errors can lead to providing a less than ideal hair coloring composition for a particular client, and, resultantly, an unhappy client.

In practice, a professional colorist typically discusses with his or her client the client's desired resulting hair color. Taking into consideration the assortment of professional hair coloring products available, the professional colorist utilizes his or her professional training and judgment, perhaps along with whatever instructions have been provided by the manufacturer of the available professional hair coloring products, to mix the appropriate products and formulate a hair coloring composition which he or she believes will provide the client's desired resulting hair color. Then, the hair coloring composition is applied to the client's hair. Given the complexity and potential for error associated with this process as noted above, it would be advantageous for the professional colorist to test or to experiment with the formulating process needed to achieve a particular customized hair coloring composition. However, this is not practical for the professional colorist for at least several reasons. For example, using the available professional hair coloring products to mix or to formulate a "test" composition may be considered not only time-consuming (especially if a client is already waiting in the salon), but also wasteful of the products used and, thus, expensive.

Additionally, in practice, a professional colorist does the mixing and formulating of such customized hair coloring products in a space or room in the salon separate and away from the client's view. Although this may be preferable given the currently practiced methods of mixing and formulating and the complexity and messiness associated with these methods, it is believed that increasing numbers of clients or customers of professional salons want to receive greater individualized advice and service from their professional colorist. To achieve such a level of service, interaction between the client and the professional colorist should be maximized so that the client feels like a partner in the entire process. Thus, it would be advantageous for the professional colorist to perform the mixing or formulating of a customized hair color composition in the presence of the client.

Consequently, a need exists for a method for formulating a custom hair color composition which is simple, accurate, and reliable, yet which also maintains the professional colorist's ability to utilize his or her professional expertise and artistic creativity in formulating the composition. Moreover, such a method should enable increased interaction between the professional colorist and the client, so that the client can feel more like a partner in the customized coloring process. A further need exists for a method which enables testing or simulating the formulation of a custom hair coloring composition and the resulting custom hair color imparted to a client's hair by such a custom hair coloring composition. Advantageously, such a method should be performed quickly and easily without being messy and wasteful of the relatively expensive professional hair coloring products.

The methods of the present invention and the means for carrying out such methods, including related systems and hair coloring products, address these needs discussed above.

### SUMMARY OF THE INVENTION

The present invention relates to methods for simulating custom hair color results, methods for selecting a desired resulting custom hair color from among possible custom hair color results, and methods for formulating custom hair coloring compositions which impart to hair such custom hair color results. The present invention also relates to means for carrying out such methods, including related systems and hair coloring products.

In a first aspect, the present invention relates to a method for simulating a resulting custom hair color imparted to hair by a custom hair coloring composition formulated from a mixture of at least two different color shade components selected from a defined collection of different color shade components available for mixing. Such a method comprises the steps of: (a) inputting into a computer system an initial hair color of the hair; (b) inputting into a computer system an amount of a first color shade component for adding to the mixture, wherein the first color shade component is selected from the defined collection; (c) inputting into the computer system an amount of a second color shade component for adding to the mixture, wherein the second color shade component is selected from the defined collection; (d) inputting, optionally, into the computer system an amount of one or more additional color shade components for adding to the mixture, wherein each of the additional color shade components is selected from the defined collection; (e) predicting with the computer system a likely resulting custom hair color based on the inputted initial hair color of the hair and the inputted amounts of each of the first, second, and optionally additional, color shade components for adding to the mixture; (f) generating with the computer system a visual image representative of the likely resulting custom hair color; and (g) displaying the visual image representative of the likely resulting custom hair color to simulate the resulting custom hair color.

In a second aspect, the present invention relates to a method for selecting a desired resulting custom hair color imparted to hair by a custom hair coloring composition formulated from a mixture of at least two different color shade components selected from a defined collection of different color shade components available for mixing, said method comprising the steps of: (a) performing a method according to the first aspect of the present invention to simulate a first possible resulting custom hair color, wherein the first possible resulting custom hair color has a corresponding visual image representative of the likely resulting custom hair color and corresponding inputted amounts of each of the first, second, and optionally additional, color shade components for adding to the mixture; (b) saving the visual image representative of the likely resulting custom hair color which corresponds to the first possible resulting custom hair color and the inputted amounts of each of the first, second, and optionally additional, color shade components for adding to the mixture which correspond to the first possible resulting custom hair color; (c) performing a method according to the first aspect of the present invention to simulate a second possible resulting custom hair color, wherein the second possible resulting custom hair color has a corresponding visual image representative of the likely resulting custom hair color and corresponding inputted amounts of each of the first, second, and optionally additional, color shade components for adding to the mixture; (d) saving the visual image representative of the likely resulting custom hair color which corresponds to the second possible resulting custom hair color and the inputted amounts of each of the first, second, and optionally additional, color shade components for adding to the mixture which correspond to the second possible resulting custom hair color; (e) performing, optionally, a method according to the first aspect of the present invention to simulate one or more additional possible resulting custom hair colors, wherein each of the additional possible resulting custom hair colors has a corresponding visual image representative of the likely resulting custom hair color and corresponding inputted amounts of each of the first, second, and optionally additional, color shade components for adding to the mixture; (f) saving, optionally, the visual image representative of the likely resulting custom hair color which corresponds to each of the additional possible resulting custom hair colors and the inputted amounts of each of the first, second, and optionally additional, color shade components for adding to the mixture which correspond to each of the additional possible resulting custom hair colors; (g) displaying for visual comparison each visual image representative of the likely resulting custom hair color which corresponds, respectively, to the first, second, and optionally additional, possible resulting custom hair colors; and (h) indicating a preference for one of the displayed visual images representative of the likely resulting custom hair colors which correspond, respectively, to the first, second, and optionally additional, possible resulting custom hair colors to select the desired resulting custom hair color.

In a third aspect, the present invention relates to a method for formulating a custom hair coloring composition which imparts to hair a desired resulting custom hair color and which comprises a mixture of at least two different color shade components selected from a defined collection of different color shade components available for mixing. One embodiment of such a method comprises the steps of: (a) performing a method according to first aspect of the present invention to simulate a desired resulting custom hair color, wherein the desired resulting custom hair color has corresponding inputted amounts of each of the first, second, and optionally additional, color shade components for adding to the mixture; (b) providing a mixing vessel for containing the mixture; (c) dispensing into the mixing vessel an amount of each of the first, second, and optionally additional, color shade components selected from the defined collection according to the inputted amounts of each of the first, second, and optionally additional, color shade components which correspond to the desired resulting custom hair color; and (d) mixing the dispensed amounts of the first, second, and optionally additional, color shade components to formulate the custom hair coloring composition.

A second embodiment of a method according to the third aspect of the present invention comprises the steps of: (a) performing a method according to the second aspect of the present invention to select a desired resulting custom hair color, wherein the desired resulting custom hair color has corresponding inputted and saved amounts of each of the first, second, and optionally additional, color shade components for adding to the mixture; (b) providing a mixing vessel for containing the mixture; (c) dispensing into the mixing vessel an amount of each of the first, second, and optionally additional, color shade components selected from the defined collection according to the inputted and saved amounts of each of the first, second, and optionally additional, color shade components which correspond to the desired resulting custom hair color; and (d) mixing the dispensed amounts of the first, second, and optionally additional, color shade components to formulate the custom hair coloring composition.

Additional aspects of the present invention relate to means for carrying out such methods as described above, including related systems and hair coloring products, and are further described below in the context of the methods of the present invention.

### DETAILED DESCRIPTION OF THE INVENTION

While the specification concludes with claims that particularly point out and distinctly claim the invention, it is believed the present invention will be better understood from the following description.

As used herein, the term "hair" refers to keratinous fibers on a living body, e.g., a person, or a non-living body, e.g., in a wig, hairpiece, or other aggregation of non-living keratinous fibers. Mammalian, preferably human, hair is preferred. Notably, hair, wool, fur, and other keratinous fibers are suitable substrates for treatment by the hair color refresher products described herein.

As used herein, the term "custom", when used to modify terms such as "hair color" or "hair coloring composition" and the like, refers to being made or done according to personal order or request. Included within such a definition are hair coloring compositions mixed and formulated by a professional colorist for one or more particular clients in a hair salon, and the hair color imparted to hair by such compositions.

The methods of the present invention comprise the steps as described above. Each of these methods and their respective steps, as well as preferred or additional elements and other aspects of the present invention, are described in detail hereinafter.

### A. Simulating a Resulting Custom Hair Color

One aspect of the present invention relates to a method for simulating a resulting custom hair color imparted to hair by a custom hair coloring composition. Typically, such custom hair coloring compositions are formulated from a mixture of at least two different color shade components selected from a defined collection of different color shade components available for mixing. These different color shade components include, for example, individually packaged professional hair coloring compositions, each of which provides a different color tone. Often, these different color shade components are provided by one manufacturer in defined collections, all of the components of which are designed to be suitable for mixing with each other to achieve hair coloring compositions of additional or different color shades within a hair coloring shade palette. A method for simulating a resulting custom hair color, which allows a professional colorist to virtually formulate and experiment with a variety of color formulations, is useful to promote the professional colorist's understanding of the mixing and formulating possibilities of different color shade components of a given defined collection.

According to the method of the present invention, simulating a resulting custom hair color comprises several steps. First, a user, for example a professional colorist or a client in a hair salon, inputs into a computer system the initial hair color of the hair which is to be colored. The initial hair color may be selected from a predetermined group of possible initial hair colors, which is presented to the user for making a selection. Such a predetermined group of possible initial hair colors may be presented to the user as a plurality of visual images of hair of different colors, or may be presented to the user as a written list of different possible hair colors. In an embodiment of the present invention, the user is presented with a plurality of visual images of hair of different colors which comprises visual images representative of light blonde hair, dark blonde hair, and medium brown hair. Visual images of hair of additional colors, such as dark brown, black, auburn, and red, may also be used in various combinations.

In one embodiment of the present invention, the method also comprises the step of inputting into the computer system a hair type of the hair which is to be colored. As with the initial hair color, the hair type may be selected from a predetermined group of possible hair types, which is presented to the user for making a selection. Such a predetermined group of possible hair types may be presented to the user as a plurality of visual images of hair of different types, or may be presented to the user as a written list of different possible hair types. In one embodiment of the present invention, the user is presented with a plurality of visual images of hair of different types which comprises visual images representative of straight hair, wavy hair, and curly hair.

Next, the user inputs into the computer system amounts of a first color shade component for adding to the mixture, a second color shade component for adding to the mixture, and, optionally, one or more additional color shade components for adding to the mixture. The amounts of each of these different color shade components may be expressed in terms of mass or volume and in any suitable unit of measurement, for example, grams. The amount of each color shade component which is inputted by the user may be limited to an amount within a set range, for example, 0 grams to 6 grams. Alternatively, the inputted amount may be unrestricted to any range.

For use in all of the methods of the present invention, any suitable computer system may be used, including a commercially available desktop, portable, or hand-held personal computer having appropriately programmed software applications installed thereon. Alternatively, custom designed devices embodying a suitable computer system may be used. The appropriately programmed software applications may be distributed to users, for example, via compact disks or other electronic storage means or may be made available for downloading from a website via the Internet. Inputting the information corresponding to the initial hair color of the hair, the hair type of the hair, and the amounts of the first, second, and any additional color shade components may be performed by any suitable means which is compatible with the computer system. For example, the information may be inputted through the use of a keyboard, a mouse, or a touch-screen.

Each of the first, second, and optionally additional, color shade components is selected from the defined collection. The defined collection comprises a plurality of different color shade components which, when added to the mixture, affect the color tone of the resulting custom hair color. The defined collection may also comprise at least one color shade component which, when added to the mixture, affects the color depth of the resulting custom hair color.

In one embodiment of the present invention, the defined collection comprises at least one color shade component for providing color tone representative of a point on a color circle corresponding to a color selected from the group consisting of ash, rose, gold, orange, red, violet, and blue. In another embodiment of the present invention, the defined collection comprises: (a) a color shade component for providing ash color tone; (b) a color shade component for providing rose color tone; (c) a color shade component for providing gold color tone; (d) a color shade component for providing orange color tone; (e) a color shade component for providing red color tone; (f) a color shade component for providing violet color tone; (g) a color shade component for providing blue color tone; and (h) a color shade component for adjusting the depth of any one of the color tones of (a) to (g) or a color tone of any mixtures thereof.

The method of the present invention then comprises the step of predicting with the computer system a likely resulting custom hair color based on the inputted initial hair color of the hair and the inputted amounts of each of the first, second, and optionally additional, color shade components for adding to the mixture. The computer system of may be appropriately programmed by one of ordinary skill in the art to predict the likely resulting custom hair color based on the inputted information. Further description of such methods for predicting a resulting hair color can be found, for example, in U.S. Patent Nos. 6980888 and 6707929.

According to the method of the present invention, the next steps comprise generating with the computer system a visual image representative of the likely resulting custom hair color, and then displaying the visual image representative of the likely resulting custom hair color to simulate the resulting custom hair color. As with the color predicting step described above, the computer system may be appropriately programmed by one of ordinary skill in the art to generate the visual image of the custom hair color. The visual image may be displayed on a computer monitor or a video display screen or in any other suitable visual medium. In one embodiment of the present invention, the step of displaying presently described comprises displaying a visual image of a color circle and the visual image representative of the likely resulting custom hair color is indicated as a point in the color circle. In another embodiment of the present invention, the step of displaying comprises displaying a visual image of hair having a color which is the likely resulting custom hair color.

According to another aspect of the present invention, an essentially inverse method may also be performed. Instead of simulating a resulting custom hair color based on inputted amounts of the different color shade components for adding to the mixture, the respective amounts of the different color shade components necessary for providing a particular resulting custom hair color may be generated based on inputting a value for a desired resulting custom hair color. Such a method for providing a mixture recipe corresponding to a desired resulting custom hair color comprises the steps of inputting into a computer system a desired resulting custom hair color, and predicting with the computer system the respective amounts of the necessary color shade components.

### B. Selecting a Desired Resulting Custom Hair Color

Another aspect of the present invention relates to a method for selecting a desired resulting custom hair color imparted to hair by a custom hair coloring composition formulated, as with the above described method, from a mixture of at least two different color shade components selected from a defined collection of different color shade components available for mixing. This method may be performed, for example, by a professional colorist, by a client in a hair salon, or by both the professional colorist and the client together.

The first step of this method comprises performing a method for simulating according to the first aspect of the present invention, as described above, to simulate a first possible resulting custom hair color. The first possible resulting custom hair color, as simulated under the method of the first aspect of the present invention, has a corresponding visual image representative of the likely resulting custom hair color and corresponding inputted amounts of each of the first, second, and optionally additional, color shade components for adding to the mixture.

The next step of this method comprises saving the visual image representative of the likely resulting custom hair color which corresponds to the first possible resulting custom hair color and the inputted amounts of each of the first, second, and optionally additional, color shade components for adding to the mixture which correspond to the first possible resulting custom hair color. This information may be saved electronically on the computer system of the present invention. Alternatively, hard copies of this information may be produced and retained to perform the step of saving.

According to this method of the present invention, the next steps comprise effectively repeating the first two steps of simulating and saving for at least a second possible resulting custom hair color, which then is compared with the first possible resulting custom hair color. More particularly, the method of the present invention comprises performing a method according to the first aspect of the present invention, as described above, to simulate a second possible resulting custom hair color. Similarly to the first possible resulting custom hair color, the second possible resulting custom hair color has a corresponding visual image representative of the likely resulting custom hair color and corresponding inputted amounts of each of the first, second, and optionally additional, color shade components for adding to the mixture. Then, this step is followed by saving the visual image representative of the likely resulting custom hair color which corresponds to the second possible resulting custom hair color and the inputted amounts of each of the first, second, and optionally additional, color shade components for adding to the mixture which correspond to the second possible resulting custom hair color.

As a purpose of this method is to allow comparison of multiple possible resulting custom hair colors, the first two steps may be repeated only for a second possible resulting custom hair color, or they may be repeated for one or more additional possible resulting custom hair colors, as desired by the user. Accordingly, the method of the present invention comprises the step of performing, optionally, a method according to the first aspect of the present invention, as described above, to simulate one or more additional possible resulting custom hair colors, wherein each of the additional possible resulting custom hair colors has a corresponding visual image representative of the likely resulting custom hair color and corresponding inputted amounts of each of the first, second, and optionally additional, color shade components for adding to the mixture. The method, then, also comprises the step of saving, optionally, the visual image representative of the likely resulting custom hair color which corresponds to each of the additional possible resulting custom hair colors and the inputted amounts of each of the first, second, and optionally additional, color shade components for adding to the mixture which correspond to each of the additional possible resulting custom hair colors.

Once the number of possible resulting custom hair colors as desired are simulated and the respective corresponding information is saved, the method of the present invention next comprises the step of displaying for visual comparison each visual image representative of the likely resulting custom hair color which corresponds, respectively, to the first, second, and optionally additional, possible resulting custom hair colors. As in the displaying step of the method of the first aspect of the invention, each of the visual images generated and saved under the presently described method may be displayed on a computer monitor or a video display screen or in any other suitable visual medium. In one embodiment, this step comprises displaying each visual image representative of the possible resulting custom hair colors as a visual image of hair having a color which is the particular possible resulting custom hair color. To allow comparison between the different possible resulting custom hair colors, the visual images may be displayed simultaneously, for example, all on one computer screen at the same time. Alternatively, the visual images may be displayed sequentially, for example, in a slide show format. Additionally, a visual image representative of the initial hair color of the hair which is to be colored may be displayed so that it may also be compared with all of the possible resulting custom hair colors.

After the possible resulting custom hair colors are displayed, the method of the present invention comprises the step of indicating a preference for one of the displayed visual images representative of the likely resulting custom hair colors which correspond, respectively, to the first, second, and optionally additional, possible resulting custom hair colors to select the desired resulting custom hair color. The preference may be indicated, for example, by inputting such information into the computer system, which can then be saved or archived. Alternatively, the preference may be indicated simply by physically motioning at the displayed visual images and/or by orally communicating such information.

### C. Formulating a Custom Hair Color Composition

A third aspect of the present invention relates to a method for formulating a custom hair coloring composition. This custom hair coloring composition imparts to hair a desired resulting custom hair color and comprises a mixture of at least two different color shade components selected from a defined collection of different color shade components available for mixing. The methods of this aspect of the present invention may be performed by a professional colorist in a hair salon. These methods allow for simple, accurate, and reliable mixing and formulating of custom hair coloring compositions, while also facilitating a professional colorist to utilize his or her professional expertise and artistic creativity in formulating the composition. Further, embodiments of these methods can be practiced to enable increased interaction between the professional colorist and the client, so that the client can feel more like a partner in the customized coloring process.

In one embodiment, the method of the present invention comprises a first step of performing a method according to first aspect of the present invention, as described above, to simulate a desired resulting custom hair color. By first simulating the desired resulting custom hair color, a professional colorist may ensure that he or she has the proper mixing ratios of the different color shade components for adding to the mixture. Additionally, both the professional colorist and a client in a hair salon may verify that the desired resulting custom hair color is indeed what should be imparted by a custom hair coloring composition made according to the mixture corresponding to the simulation. In the first step of this embodiment, the desired resulting custom hair color has, as simulated under the method of the first aspect of the present invention, corresponding inputted amounts of each of the first, second, and optionally additional, color shade components for adding to the mixture.

In a second embodiment, the method of the present invention comprises a first step of performing a method according to the second aspect of the present invention, as described above, to select a desired resulting custom hair color. This embodiment of the present invention is advantageous when a professional colorist and/or a client in a hair salon are uncertain of which resulting custom hair color is desired. By simulating several possible resulting custom hair colors for comparison before any hair coloring compositions are formulated, it improves the probability that the resulting hair color which is most desired by the client is selected. In turn, the appropriate hair coloring composition ultimately is formulated. In the first step of this second embodiment, the desired resulting custom hair color has corresponding inputted and saved amounts of each of the first, second, and optionally additional, color shade components for adding to the mixture.

According to all embodiments, the method of this aspect of the present invention next comprises the steps of providing a mixing vessel for containing the mixture, and dispensing into the mixing vessel an amount of each of the first, second, and optionally additional, color shade components selected from the defined collection. Any mixing vessel capable of containing the different color shade components and allowing the components to be mixed is suitable for use herein. The dispensed amount of each of these components is according to the inputted (and, in the second embodiment of this method, saved) amounts of each of the first, second, and optionally additional, color shade components which correspond to the desired resulting custom hair color.

As discussed above with respect to the first aspect of the present invention, each of the first, second, and optionally additional, color shade components is selected from the defined collection. The defined collection comprises a plurality of different color shade components which, when added to the mixture, affect the color tone of the resulting custom hair color. The defined collection may also comprise at least one color shade component which, when added to the mixture, affects the color depth of the resulting custom hair color.

In one embodiment of the present invention, the defined collection comprises at least one color shade component for providing color tone representative of a point on a color circle corresponding to a color selected from the group consisting of ash, rose, gold, orange, red, violet, and blue. In another embodiment of the present invention, the defined collection comprises: (a) a color shade component for providing ash color tone; (b) a color shade component for providing rose color tone; (c) a color shade component for providing gold color tone; (d) a color shade component for providing orange color tone; (e) a color shade component for providing red color tone; (f) a color shade component for providing violet color tone; (g) a color shade component for providing blue color tone; and (h) a color shade component for adjusting the depth of any one of the color tones of (a) to (g) or a color tone of any mixtures thereof.

In a further embodiment of the present invention, each of the color shade components of the defined collection is in a form selected from the group consisting of a crème, a powder, and granules.

In yet another embodiment of the present invention, each of the color shade component of the defined collection is in the form of granules, and the step of dispensing is performed with the use of a plurality of dosing devices. Each device in this plurality of dosing devices corresponds to one of the different color shade components. Further, each of the dosing devices comprises (i) a storage vessel containing the granules, (ii) a dispensing head connected to the storage vessel and having a dispensing opening, and (iii) an actuating means within the dispensing head for controlling dispensing of the granules from the storage vessel and through the dispensing opening.

According to all embodiments, the method of this aspect of the present invention finally comprises the step of mixing the dispensed amounts of the first, second, and optionally additional, color shade components to formulate the custom hair coloring composition. The physical mixing of the components may be performed by any suitable means or with any suitable technique known to one of ordinary skill in the art. Typically, the mixture of the different color shade components is subsequently mixed with a peroxide developer solution and a colorless crème base to form a hair coloring composition capable of coloring the hair.

In an embodiment of the present invention, at least one of either the step of dispensing or the step of mixing is performed by a professional colorist within the visual observation of a hair coloring client. For example, at least one of either the step of dispensing or the step of mixing is performed by the professional colorist at a portable hair coloring service cart in an area of the hair salon physically proximate to a chair in which the hair coloring client is sitting. Advantageously, color tone components in the form of granules are used when dispensing and/or mixing is performed in the presence of the client.

Related to these embodiments of the present invention discussed immediately above is an improved method for providing a professional hair coloring treatment to a client in a hair salon. Such a method may comprise the steps of formulating a custom hair coloring composition according to the methods of the present invention, wherein the formulating is performed in the presence of the client, and applying the custom hair coloring composition to the hair of the client.

According to a further aspect of the present invention, the opinion of the professional colorist and/or of the client regarding the resulting custom hair color imparted to the hair by the custom hair color composition may be recorded and archived along with information on the particular color shade components and their amounts added to the mixture which was utilized. This allows the professional colorist or the client to reference this information at a later date, for example, when the client returns to the hair salon for a subsequent hair coloring treatment. In an instance where a client may go to a new hair salon different from where he or she went for a previous hair coloring treatment, the recorded and archived information may be communicated from the previous hair salon to the new hair salon. Suitable means of communicating such information include, but are not limited to, the telephone, facsimile, electronic mail, and the Internet. Such steps lead to a particular client ultimately being able to obtain a resulting custom hair color which is most desired by or most ideal for that particular client.

All documents cited in the Detailed Description of the Invention are, in relevant part, incorporated herein by reference; the citation of any document is not to be construed as an admission that it is prior art with respect to the present invention. To the extent that any meaning or definition of a term in this written document conflicts with any meaning or definition of the term in a document incorporated by reference, the meaning or definition assigned to the term in this written document shall govern.

While particular embodiments of the present invention have been illustrated and described, it would be obvious to those skilled in the art that various other changes and modifications can be made without departing from the scope of the invention. It is therefore intended to cover in the appended claims all such changes and modifications that are within the scope of this invention.

## Claims

1. A method for formulating a custom hair coloring composition which imparts to hair a desired resulting custom hair color and which comprises a mixture of at least two different color shade components selected from a defined collection of different color shade components available for mixing, said method comprising the steps of:
(a) inputting into a computer system an initial hair color of said hair;
(b) inputting into a computer system an amount of a first color shade component for adding to said mixture, wherein said first color shade component is selected from said defined collection;
(c) inputting into said computer system an amount of a second color shade component for adding to said mixture, wherein said second color shade component is selected from said defined collection;
(d) inputting, optionally, into said computer system an amount of one or more additional color shade components for adding to said mixture, wherein each of said additional color shade components is selected from said defined collection;
(e) predicting with said computer system a likely resulting custom hair color based on the inputted initial hair color of said hair and the inputted amounts of each of said first, second, and optionally additional, color shade components for adding to said mixture;
(f) generating with said computer system a visual image representative of said likely resulting custom hair color;
(g) displaying said visual image representative of said likely resulting custom hair color to simulate said resulting custom hair color;
(h) performing the method according to steps (a) to (g) to select said desired resulting custom hair color, wherein said desired resulting custom hair color has corresponding inputted and saved amounts of each of said first, second, and optionally additional, color shade components for adding to said mixture;
**characterized in**
(i) providing a mixing vessel for containing said mixture;
(j) dispensing into said mixing vessel an amount of each of said first, second, and optionally additional, color shade components selected from said defined collection according to the inputted and saved amounts of each of said first, second, and optionally additional, color shade components which correspond to said desired resulting custom hair color; and
(k) mixing the dispensed amounts of said first, second, and optionally additional, color shade components to formulate said custom hair coloring composition, wherein each of said defined collection of different color shade components is in the form of granules, and wherein said step (j) of dispensing is performed with the use of a plurality of dosing devices, each of said plurality of dosing devices corresponding to one of said different color shade components, wherein each of said dosing devices comprises (i) a storage vessel containing said granules, (ii) a dispensing head connected to said storage vessel and having a dispensing opening, and (iii) an actuating means within said dispensing head for controlling dispensing of said granules from said storage vessel and through said dispensing opening.

2. A method according to claim 1, wherein at least one of said step (j) of dispensing and said step (k) of mixing is performed by said professional colorist within the visual observation of a hair coloring client.

## Patentansprüche

1. Verfahren zur Formulierung einer kundenspezifischen Haarfärbe-Zusammensetzung, die Haaren ein gewünschtes, kundenspezifisches Haarfarbergebnis verleiht und die eine Mischung aus mindestens zwei verschiedenen Farbtonkomponenten umfasst, die ausgewählt sind aus einer festgelegten Auswahl unterschiedlicher Farbtonkomponenten, die gemischt werden können, wobei das Verfahren die folgenden Schritte umfasst:
(a) Eingeben einer anfänglichen Haarfarbe des Haars in ein Computersystem;
(b) Eingeben einer Menge einer ersten Farbtonkomponente, die der Mischung zugesetzt wird, in ein Computersystem, wobei die erste Farbtonkomponente aus der festgelegten Auswahl ausgewählt wird;
(c) Eingeben einer Menge einer zweiten Farbtonkomponente, die der Mischung zugesetzt wird, in ein Computersystem, wobei die zweite Farbtonkomponente aus der festgelegten Auswahl ausgewählt wird;
(d) optional Eingeben einer Menge einer oder mehrerer zusätzlicher Farbtonkomponenten, die der Mischung zugesetzt werden, in das Computersystem, wobei jede der zusätzlichen Farbtonkomponenten aus der festgelegten Auswahl ausgewählt wird;
(e) Voraussagen eines wahrscheinlichen, kundenspezifischen Haarfarbergebnisses mit dem Computersystem auf der Basis der eingegebenen anfänglichen Haarfarbe des Haars und der jeweils eingegebenen Mengen der ersten, zweiten und optional zusätzlichen Farbtonkomponenten, die der Mischung zugesetzt werden;
(f) Erzeugen einer optischen Abbildung, die das wahrscheinliche kundenspezifische Haarfarbergebnis wiedergibt, mit dem Computersystem;
(g) Anzeigen der optischen Abbildung, die das wahrscheinliche kundenspezifische Haarfarbergebnis wiedergibt, um das kundenspezifische Haarfarbergebnis zu simulieren;
(h) Ausführen des Verfahrens gemäß der Schritte (a) bis (g), um das gewünschte kundenspezifische Haarfarbergebnis auszuwählen, wobei das gewünschte kundenspezifische Haarfarbergebnis jeweils entsprechende eingegebene und gespeicherte Mengen an den ersten, zweiten und optional zusätzlichen Farbtonkomponenten, die der Mischung zugegeben werden, aufweist;
**dadurch gekennzeichnet, dass**
(i) ein Mischgefäß bereitgestellt wird, das die Mischung aufnimmt;
(j) jeweils eine Menge der ersten, zweiten und optional zusätzlichen Farbtonkomponenten, die aus der festgelegten Auswahl ausgewählt werden, jeweils entsprechend der eingegebenen und gespeicherten Mengen der ersten, zweiten und optional zusätzlichen Farbtonkomponenten, die dem gewünschten kundenspezifischen Haarfarbergebnis entsprechen, in dem Mischgefäß dispergiert wird; und
(k) Mischen der dispergierten Mengen an ersten, zweiten und optional zusätzlichen Farbtonkomponenten, um die kundenspezifische Haarfärbe-Zusammensetzung zu formulieren, wobei jede der festgelegten Auswahlen an unterschiedlichen Farbtonkomponenten in Form von Granalien vorliegt, und wobei der Dispergierungsschritt (j) unter Verwendung einer Vielzahl von Dosierungseinrichtungen durchgeführt wird, wobei jede von der Vielzahl von Dosierungseinrichtungen einer der verschiedenen Farbtonkomponenten entspricht, wobei jede der Dosierungseinrichtungen (i) ein Aufbewahrungsgefäß, das die Granalien enthält, (ii) einen Dispergierungskopf, der mit dem Aufbewahrungsgefäß verbunden ist und der eine Abgabeöffnung aufweist, und (iii) ein Betätigungsmittel in dem Dispergierungskopf umfasst, um die Abgabe der Granalien aus dem Aufbewahrungsgefäß und durch die Abgabeöffnung hindurch zu steuern.

2. Verfahren nach Anspruch 1, wobei der Dispergierungsschritt (j) und/oder der Mischungsschritt (k) von dem professionellen Koloristen unter Beobachtung eines Haarfärbekunden durchgeführt wird.

## Revendications

1. Procédé pour formuler une composition de coloration capillaire personnalisée qui communique aux cheveux une coloration capillaire personnalisée résultante souhaitée et qui comprend un mélange d'au moins deux composants de nuance de couleur différents choisis parmi une collection définie de différents composants de nuance de couleur disponibles pour mélange, ledit procédé comprenant les étapes consistant à :
(a) saisir dans un système informatique la couleur capillaire initiale desdits cheveux ;
(b) saisir dans un système informatique une quantité d'un premier composant de nuance de couleur pour ajout audit mélange, dans lequel ledit premier composant de nuance de couleur est choisi parmi ladite collection définie ;
(c) saisir dans ledit système informatique une quantité d'un deuxième composant de nuance de couleur pour ajout audit mélange, dans lequel ledit deuxième composant de nuance de couleur est choisi parmi ladite collection définie ;
(d) saisir, facultativement, dans ledit système informatique une quantité d'un ou plusieurs composants de nuance de couleur supplémentaires pour ajout audit mélange, dans lequel chacun desdits composants de nuance de couleur supplémentaires est choisi parmi ladite collection définie ;
(e) prédire avec ledit système informatique une coloration capillaire personnalisée résultante probable basée sur la couleur initiale saisie des cheveux et les quantités saisies de chacun desdits premier, deuxième composants de nuance de couleur et facultativement des composants de nuance de couleur supplémentaires pour ajout audit mélange ;
(f) générer avec ledit système informatique une image visuelle représentative de ladite coloration capillaire personnalisée résultante probable ; et
(g) afficher ladite image visuelle représentative de ladite coloration capillaire personnalisée résultante probable de façon à simuler ladite coloration capillaire personnalisée résultante.
(h) exécuter le procédé selon les étapes (a) à (g) pour sélectionner ladite coloration capillaire personnalisée résultante souhaitée, dans lequel ladite coloration capillaire personnalisée résultante souhaitée a des quantités saisies et enregistrées correspondantes de chacun desdits premier, deuxième composants de nuance de couleur, et facultativement des composants de nuance de couleur supplémentaires pour ajout audit mélange ;
**caractérisé par**
(i) la fourniture d'un récipient mélangeur pour contenir ledit mélange ;
(j) la distribution dans ledit récipient mélangeur d'une quantité de chacun desdits premier, deuxième composants de nuance de couleur, et facultativement des composants de nuance de couleur supplémentaires choisis parmi ladite collection définie selon les quantités saisies et enregistrées de chacun desdits premier, deuxième composants de nuance de couleur, et facultativement des composants de nuance de couleur supplémentaires qui correspondent à ladite coloration capillaire personnalisée résultante souhaitée ; et
(k) le mélange des quantités distribuées desdits premier, deuxième composants de nuance de couleur, et facultativement des composants de nuance de couleur supplémentaires pour formuler ladite composition de coloration capillaire personnalisée, dans lequel chacun de ladite collection définie des différents composants de nuance de couleur est sous la forme de granules, et dans lequel ladite étape (j) de distribution est effectuée en utilisant une pluralité de dispositifs de dosage, chacun de ladite pluralité de dispositifs de dosage correspondant à un desdits composants de nuance de couleur différents, dans lequel chacun desdits dispositifs de dosage comprend (i) un récipient de stockage contenant lesdits granules, (ii) une tête de distribution reliée audit récipient de stockage et ayant une ouverture de distribution, et (iii) un moyen d'actionnement au sein de ladite tête de distribution pour contrôler la distribution desdits granules à partir dudit récipient de stockage et à travers ladite ouverture de distribution.

2. Procédé selon la revendication 1, dans lequel au moins une de ladite étape (j) de distribution et de ladite étape (k) de mélange est effectuée par ledit professionnel en coloration avec l'observation visuelle d'un client de coloration capillaire.
